## Europäisches Patentamt
## European Patent Office
## Office européen des brevets

(19)

(11) Veröffentlichungsnummer: **0 146 865 B1**

(12) **EUROPÄISCHE PATENTSCHRIFT**

(45) Veröffentlichungstag der Patentschrift: 27.02.91

(51) Int. Cl.⁵: **H03K 3/84**

(21) Anmeldenummer: **84115129.3**

(22) Anmeldetag: **11.12.84**

(54) Verfahren zum Erzeugen zufallsähnlicher Binärzeichenfolgen.

(30) Priorität: 24.12.83 DE 3346906

(43) Veröffentlichungstag der Anmeldung:
03.07.85 Patentblatt 85/27

(45) Bekanntmachung des Hinweises auf die
Patenterteilung:
27.02.91 Patentblatt 91/09

(84) Benannte Vertragsstaaten:
**AT BE CH DE FR GB LI NL**

(56) Entgegenhaltungen:
**DE-A- 2 142 413**
**FR-A- 2 290 090**
**US-A- 4 023 026**
**US-A- 4 048 480**
**US-A- 4 115 657**

(73) Patentinhaber: **ANT Nachrichtentechnik GmbH**
**Gerberstrasse 33**
**D-7150 Backnang(DE)**

(72) Erfinder: **Glitz, Ekkehard, Ing.grad.**
**Stresemannstrasse 26/4**
**D-7150 Backnang(DE)**
Erfinder: **Wewerka, Heinz, Dipl.-Ing.**
**Seelacherweg 51**
**D-7150 Backnang(DE)**

## Beschreibung

Die Erfindung betrifft ein Verfahren zum Erzeugen zufallsähnlicher Binärzeichenfolgen gemäß Oberbegriff des Patentanspruches 1.

Ein solches Verfahren ist durch die DE -C- 24 51 711 bekannt geworden.

Zufallsähnliche Zeichenfolgen werden beispielsweise für die Ver- bzw. Entschlüsselung von Informationen in Chiffriereinrichtungen benötigt. Diese Folgen müssen eine Reihe von Eigenschaften aufweisen, um den Forderungen der Kryptotechnik nachzukommen:

a- ) Lange Periode (quasi unendlich)

b- ) Wiederholbarkeit

c- ) statistisches. d.h. einem echten Zufallstext nahekommendes Testverhalten

d- ) komplexe Bildungsgesetze

e- ) eine Vielzahl von Möglichkeiten zur Einstellung und Änderung der Bildungsgesetze durch Programme

f) kalkulierbare Dechiffriersicherheit

g- ) hohe Arbeitsgeschwindigkeiten.

Das durch die obige deutsche Patentschrift bekanntgewordene Verfahren geht von der für das Bilden langer Perioden notwendigen Voraussetzung aus. daß die von den einzelnen Impulsfolgegeneratoren nämlich Zähler und oder rückgekoppelte Schieberegister gelieferten Impulsfolgen in der Anzahl ihrer Bitstellen je Periode untereinander teilerfremd sind. was dadurch erreicht wird. daß die Anzahl der Bitstellen je Periode eine Primzahl oder das Produkt weniger Primzahlen ist

Die Verknüpfung mehrerer Binärzeichenfolgen mit unterschiedlichen. teilerfremden Periodenlängen ergibt eine Binärzeichenfolge mit einer Periodenlänge gleich dem Produkt der Periodenlänge der der Verknüpfung unterworfenen Binärzeichenfolgen

Wiederholtes Verknüpfen verschiedener Binärzeichenfolgen mit teilerfremden Periodenlängen erlaubt das Gewinnen von Binärzeichenfolgen mit extrem langen Perioden. und es können durch Steuermöglichkeiten für Zähler und Schieberegister die einzelnen Binärzeichenfolgen und damit auch die Binärzeichenfolge mit extrem langer Periode fortlaufend in unregelmäßiger Weise geändert werden. Weiterhin werden die zu verknüpfenden Binärzeichenfolgen fortlaufend untereinander getauscht. indem die von den einzelnen Teilfolgegeneratoren bzw. Schieberegistern gelieferten Binärzeichenfolgen als Störimpulsfolgen durch gesteuerte Zuordnerschaltungen in fortlaufendem und unregelmäßigem Wechsel anderen rückgekoppelten Schieberegistern oder anderen Eingängen eines rückgekoppelten Schieberegisters zugeführt werden. Mit einem solchen Zeichengenerator erzielt man zwar eine sehr lange Periode, doch, will man noch eine größere Periodenlänge erreichen, so steigt der Schaltungsaufwand sehr steil an, weil aufgrund der Voraussetzung, daß die von den einzelnen Impulsfolgegeneratoren gelieferten Impulsfolgen in der Anzahl ihrer Bitstellen je Periode untereinander teilerfremd sind, erforderlich ist, daß höhere Primzahlen zusätzlich verwendet werden müssen, was sich durch zusätzlichen Einsatz von entsprechend längeren Schieberegistern ausdrückt. Technische und technologische Fortschritte in der Datenverarbeitung führten und führen zu höheren Verarbeitungs- und Übertragungsgeschwindigkeiten. Damit ist auch eine Erhöhung der Arbeitsgeschwindigkeit eines Zeichengenerators der Kryptogeräte erforderlich. Die Forderung nach erhöhter Arbeitsgeschwindigkeit der Zeichengeneratoren und die Tatsache der höheren Geschwindigkeit von Datenverarbeitungsanlagen ziehen aber auch eine weitere Verlängerung der Periodendauer der Binärzeichenfolgen mit sich. um eine entsprechende Kryptosicherheit zu gewährleisten. Bei der zeichenweisen oder wortweisen Verschlüsselung von Texten. bei der für jede Bitstelle ein separater Zeichengenerator vorgesehen ist. die nach unterschiedlichen Bildungsgesetzen arbeiten. ist es daher erforderlich. daß diese separaten Zeichengeneratoren jeweils einen unterschiedlichen Aufbau und eine unterschiedliche Anordnung aufweisen Der Aufwand hierfür. auch unter der Voraussetzung der unterschiedlichen teilerfremden Impulsfolgen gesehen. ist enorm

Die der Erfindung zugrundeliegende Aufgabe war. ein Verfahren der eingangs beschriebenen Art anzugeben. welches bei wenig zusätzlichem Aufwand zufallsähnliche Binärzeichenfolgen mit für sehr viel längerer Periode zu liefern im Stande ist

Die Lösung erfolgt mit den im Patentanspruch 1 angegebenen Merkmalen

Die Unteransprüche geben vorteilhafte Weiterbildungen des erfindungsgemäßen Verfahrens an

Das erfindungsgemäße Verfahren weist die Vorteile auf daß mit geringem zusätzlichem Schaltungsaufwand eine wesentlich längere Periodendauer für die Binärzeichenfolge erreicht werden kann. Der Grundgedanke der Erfindung besteht darin. daß auch Impulsfolgengeneratoren verwendet werden können. welche Impulsfolgen liefern. die in der Anzahl ihrer Bitstellen je Periode untereinander teilergleich sind. Damit sich Gesamtimpulsfolgen ergeben. deren Periodenlänge sich aus der Multiplikation der Einzelperiodenlängen der Generatoren ergibt. werden die Impulsfolgen der Einzelgeneratoren laufend in Versatz gehalten. d.h. nach Ablauf der Periode des ersten Generators wird die Phasenlage der Impulsfolge des zweiten Generators durch Ausblenden eines Taktimpulses verzögert.

Auf diese Weise ist es möglich, sehr lange Gesamtperioden zu erzeugen, ohne hohe Primzahlen und damit lange Schieberegisterketten benutzen zu müssen. Mit dem geringeren zusätzlichen Schaltungsaufwand ist auch ein kleinerer zusätzlicher Raumbedarf sowie eine geringere zusätzliche Verlustleistung verbunden. Von großem Vorteil ist auch die Verwendungsmöglichkeit von in sich vollkommen gleichen Generatormoduln. Dadurch ergibt sich wiederum die Möglichkeit der Integration der Schaltungsanordnung in einem Großschaltkreis. Durch diese Realisierungsmöglichkeit als Großschaltkreis geben sich wiederum ein kleinerer Raumbedarf, eine geringere Verlustleistung und geringere Kosten. Zusätzlich erbringt der Großschaltkreis eine höhere Zuverlässigkeit und ermöglicht hohe Arbeitsgeschwindigkeiten.

Es folgt nun die Beschreibung der Erfindung anhand der Figuren.

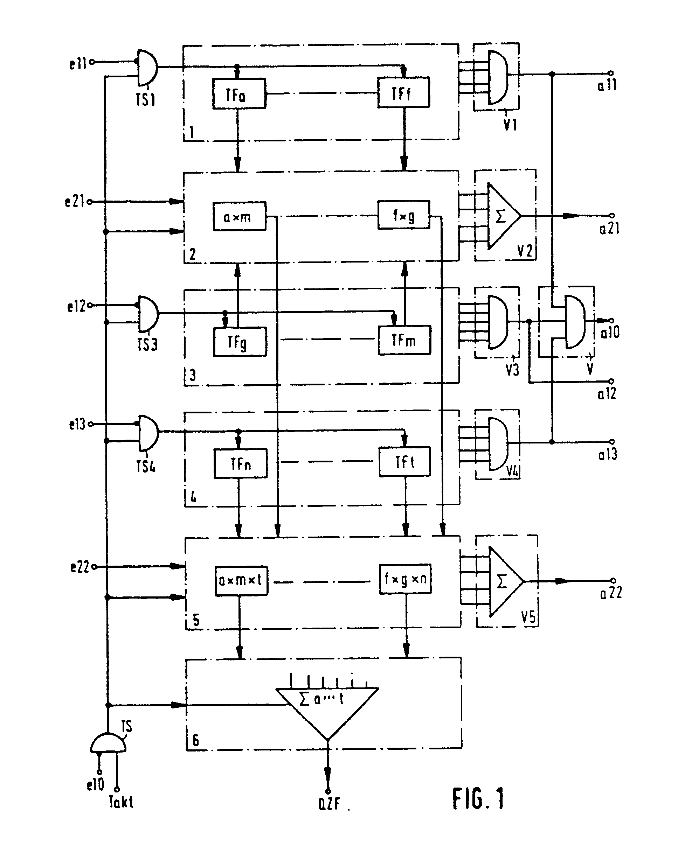

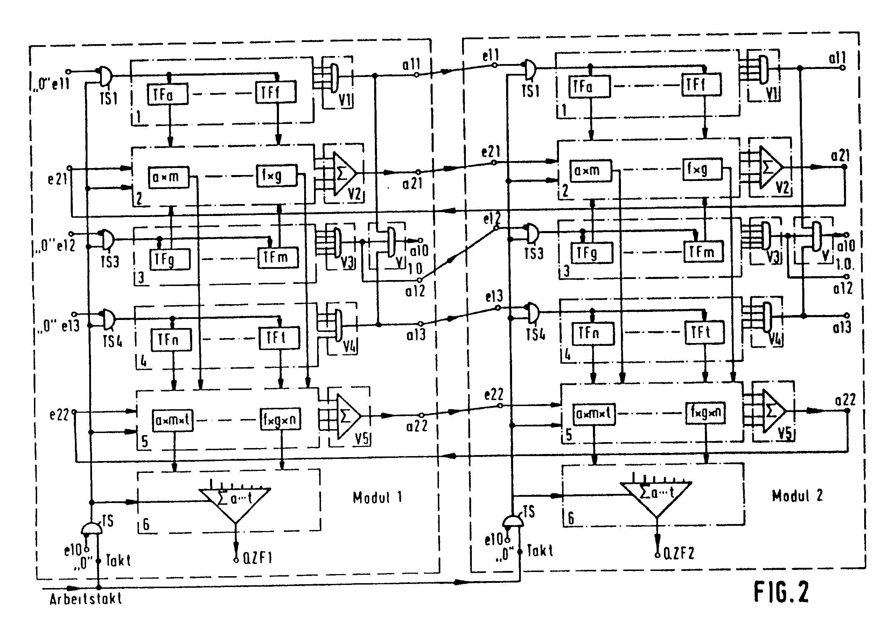

In Figur 1 ist ein Ausführungsbeispiel für einen Generatormodul gemäß der Erfindung dargestellt. Die Figuren 2 bis 4 zeigen verschiedene Verknüpfungsmöglichkeiten mehrerer Generatormodule.

Der Generatormodul gemäß Figur 1 zeigt die Verknüpfung mehrerer Teilfolgen TFa bis TFt zu einer Ausgangsfolge QZF mit quasizufälligen Eigenschaften. In der Anordnung nach Figur 1 werden in den durch strichpunktierte Rahmen zusammengefaßte Wirkungsgruppen 1 bis 6 in der Wirkungsrichtung von oben nach unten die binären Zeichenfolgen zu einer Quasizufallsbinärzeichenfolge QZF aufbereitet. Die Wirkungsbaugruppen 1, 3 und 4 enthalten Teilfolgegeneratoren TFa bis TFt mit unterschiedlichen, d.h. teilerfremden Umlaufperioden. Die Teilfolgegeneratoren können beispielsweise als rückgekoppelte Schieberegister maximaler Periode sein, die vorzugsweise eine Primzahl oder ein Produkt aus wenigen Primzahlen ist. Die Wirkungsbaugruppen 2 und 5 enthalten Einrichtungen zur logischen Verknüpfung von Binärsignalen. Es können hierfür UND-, ODER-, Exlusiv- ODER-Glieder, Zuordner, Multiplexer, Wähler, Koppler usw verwendet werden. In dem Ausführungsbeispiel nach Figur 1 werden in der Wirkungsbaugruppe 2 und 5 Produkt bildende Schaltungen verwendet, welche die Teilfolgen a bis f mit den Teilfolgen m bis g multipliziert. Das Ergebnis wird der weiteren Wirkungsbaugruppe 5 zugeführt, welche weitere Zuordnungen und Multiplikationen mit Teilfolgen t bis n aus der Gruppe 4 durchführt. Die Wirkungsbaugruppe 6 faßt die Ergebnisse aus der Wirkungsbaugruppe 5 zusammen und bildet die Ausgangsfolge QZF, die somit abhängig ist von allen einzelnen Teilfolgen TFa bis TFt.

Für eine solche Generatoranordnung gibt es mehrere Einstellmöglichkeiten, erstens durch eine Voreinstellung der Teilfolgegeneratoren, zweitens durch die Steuerbarkeit der Zuordner in den Wirkungsebenen 2 und 5, wobei die Zuordnung geändert werden kann, drittens in der Steuerbarkeit der Schieberegisterketten in den Wirkungsbereichen 1, 3 und 4, indem die Rückkoppelung dieser Schieberegister variiert wird, und schließlich viertens in einer weiteren Störbeeinflußung der Schieberegisterketten der Wirkungsebenen 1, 3 und 4, indem mittels Torschaltungen TS, TS1 bis TS4 einzelne Takte für die Schieberegisterketten einer Wirkungsebene oder des ganzen Moduls ausgeblendet werden.

Die Wirkungsebenen der Schieberegisterstufen und der Zuordner weisen zusätzlich Verknüpfungsschaltungen V1 bis V5 auf, welche die Periode der Teilfolgegeneratoren überwachen. Die Verknüpfungsschaltungen VI, V3 und V4 der Wirkungsebenen der rückgekoppelten Schieberegisterketten sind Konjuktionsschaltungen, welche eine binäre Eins an ihrem Ausgang abgeben, wenn ein bestimmtes Wort durch alle in der jeweiligen Gruppe aktiven Teilfolgen gebildet wird. Dieses Wort tritt einmal je Umlauf der Gruppenperiode auf und führt dann zu dem repräsentativen Signal an den Ausgängen a11, a12 und a13. Eine weitere Konjunktionsschaltung V faßt diese drei Ausgänge zusammen und führt am Ausgang a10 ein für die Gesamtperiode des Generatormoduls repräsentative Signalaussage. Die Verknüpfungsschaltungen V2 und V5 bilden die Summensignale aus den in der jeweiligen Wirkungsgruppe anliegenden Teilfolgensignale TFa bis TFm bzw. TFa bis TFt. An den Ausgängen a21 bzw. a22 dieser Summenschaltungen stehen damit Binärzeichenfolgen mit der maximalen Periodenlänge gleich dem Produkt der Längen aller der Verknüpfungsschaltungen zugeführten Binärzeichenfolgen an. Die Signaleingänge e21 und e22 wirken auf die Wirkungsbaugruppen 2 bzw. 5 in der Art, daß innerhalb dieser Baugruppen die logische Verknüpfung der Teilfolgen-Signale und oder die Zuordnung der Eingangssignale dieser Baugruppen zu deren Ausgängen in Abhängigkeit der logischen Wertigkeit der Eingangssignale an e21 und e22 verändert werden.

Die Figur 2 zeigt ein Ausführungsbeispiel der Erfindung mit zwei miteinander verbundenen Generatormoduln. Beide Generatormoduln werden mit dem gemeinsamen Arbeitstakt versorgt, wobei in beiden Fällen mit e10 = 0 der Takt für beide Moduln freigegeben wird.

Es folgt nun die Beschreibung der Wirkung der einzelnen Verbindungen zwischen den Moduln.

Die Verbindung a11 von Modul 1 nach e11 Modul 2 bewirkt, daß immer dann, wenn die Wirkungsbaugruppe 1 (Stufe 1) des Moduls 1 ein Periodensignal a11 meldet, über die Eingangsschaltung e11 des Moduls 2 ein Arbeitstakt für die Gruppe 1 des Moduls 2 ausgeblendet wird. Die Teilfolgenregister der Wirkungsbaugruppe 1 des Moduls 2 erscheinen nach jeder Ausblendung des Taktes um jeweils ein Bit phasenverschoben gegenüber den Registern der Gruppe 1 des Moduls 1. Da das Periodensignal a11 des Moduls 1 pro Periodenumlauf die Register der Gruppe 1 des Moduls 2 um eine Bitstelle verschiebt, ist leicht einzusehen, daß die Gesamtperiode der Wirkungsbaugruppen 1 des Moduls 1 und des Moduls 2 gleich dem Produkt der Einzelgruppenperioden ist. In entsprechender Weise wirken die Verbindungen a12 von Modul 1 nach e12 Modul 2 sowie a13 Modul 1 nach e13 Modul 2. Über e12 wird die Gruppe 3 des Moduls 2 und über e13 die Gruppe 4 von Modul 2 verschoben.

Betrachtet man insgesamt die zu verschiedenen Zeitpunkten stattfindenden Verschiebungen der Gruppen 1, 3 und 4 des Moduls 2 in Abhängigkeit des Periodenumlaufes der Gruppen 1, 3 und 4 des Moduls 1. so ist ebenfalls leicht einzusehen, daß die Gesamtperiode der Anordnung gleich dem Produkt aller beteiligten Unterperioden ist. Die Gesamtperiode dieser Zwillingsanordnung ist gleich dem Produkt der Perioden der beiden Quasizufallsfolgen QZF1 und QZF2.

Die Verbindung a21 von Modul 1 nach e21 von Modul 2 bewirkt. daß die logischen Verknüpfungen in der Gruppe 2 des Moduls 2 in Abhängigkeit der Summensignale an a21 beeinflußt werden. Die Verbindung von a22 Modul 1 nach e22 Modul 2 wirkt in derselben Weise. Die beiden Rückkopplungsverbindungen von a21 Modul 2 nach e21 Modul 1 bzw a22 Modul 2 nach e22 Modul 1 wirken in gleicher Weise und ermöglichen damit auch Änderungen in Modul 1 in Abhängigkeit der jeweiligen Einstellung in Modul 2

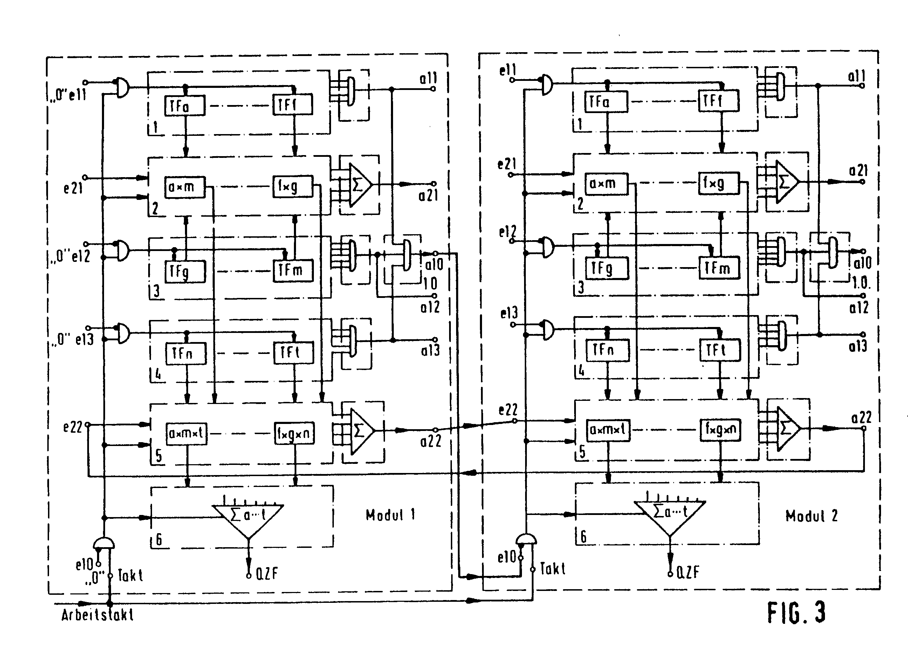

Eine andere Verbindung zwischen zwei Moduln zeigt die Figur 3. Hier wird der Takt für den Generatormodul 1 durch e10 = 0 dauernd freigegeben Für Modul 2 dagegen wird der Takt durch die Verbindung a10 Modul 1 nach e10 Modul 2 immer dann ausgeblendet. wenn der Modul 1 eine Periode durchlaufen hat. Durch die beiden Verbindungen a22 von Modul 1 nach e22 Modul 2 sowie von a22 Modul 2 nach e22 Modul 1 werden die logischen Verknüpfungsschaltungen in der Wirkungsbaugruppe 5 jeweils in Abhängigkeit aller Teilfolgen des anderen Generatormoduls beeinflußt.

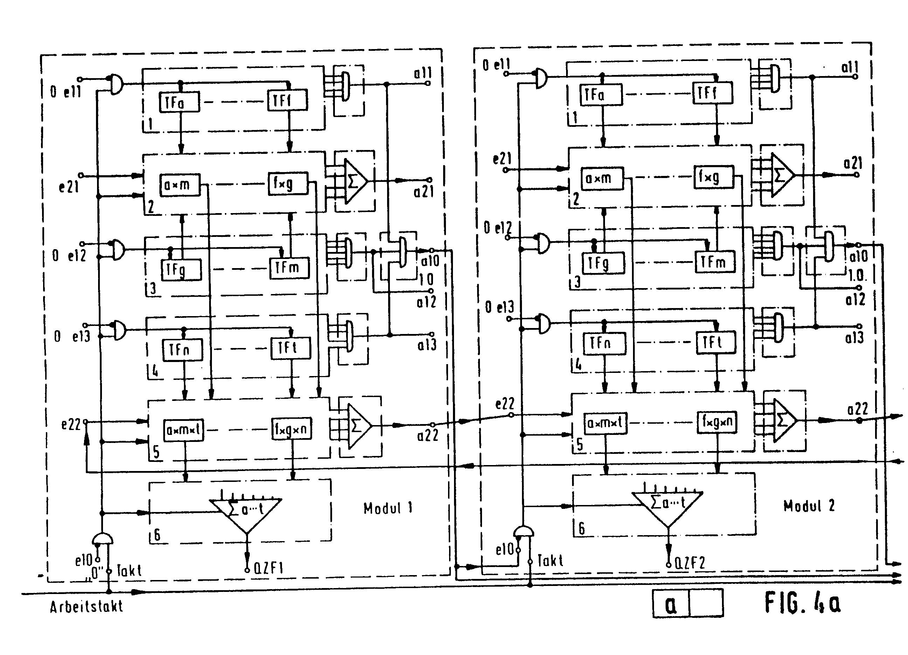

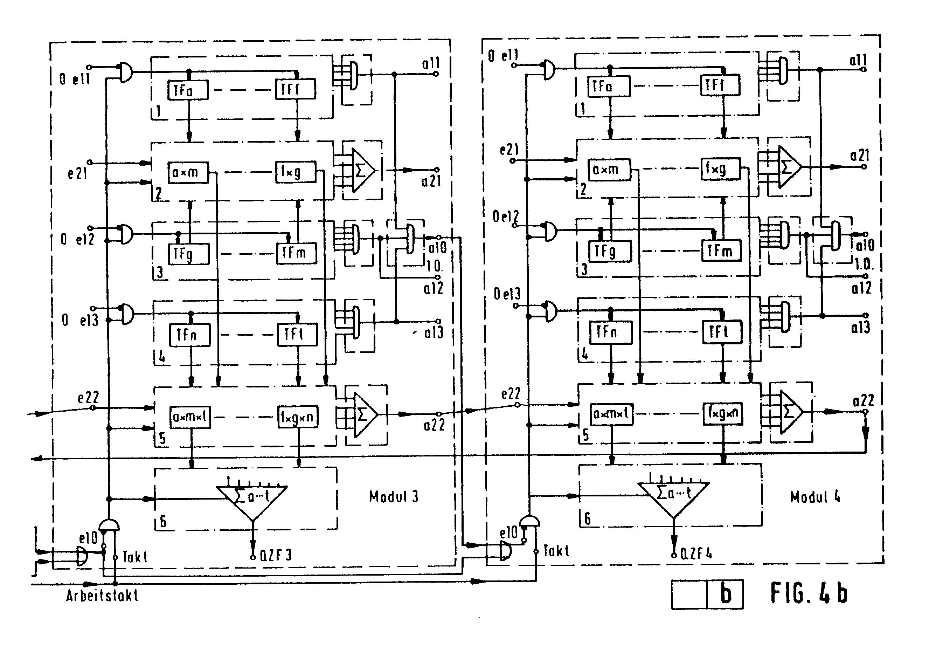

Die Figur 4. die aus den beiden Teilfiguren 4a und b auf jeweils einem Blatt besteht. zeigt eine Konfiguration mit vier Moduln, die in gleicher Weise geschaltet sind wie die beiden Generatormoduln nach Figur 3. Hier erfolgt eine Taktausblendung bei einem Generatormodul immer dann. wenn einer der vorhergehenden Generatormoduln seine Periode durchläuft. Der erste Generatormodul 1 arbeitet ohne Taktausblendung. der Eingang e10 seiner Takttorschaltung TS ist mit einer binären Null belegt. Bei den beiden Generatormoduln 3 und 4 sind vor dem Sperreingang der Torschaltung TS für die Sperrung des Taktes für den ganzen Modul jeweils ein ODER-Glied eingefügt, auf dessen Eingänge die für die Gesamtperiode repräsentativen Signale a10 der vorhergehenden Generatormodule 1, 2 bzw. 1, 2 und 3 geführt sind. Die Ringverbindungsschaltung von a22 nach e22 in der Wirkungsebene 5 besteht bei dieser Anordnung nach Figur 4 ebenso wie in Figur 3 wobei der Ring lediglich von zwei auf vier Generatormoduln erweitert wurde.

## Ansprüche

1. Verfahren zum Erzeugen zufallsähnlicher Binärzeichenfolgen mit langer Periode unter Verwendung eines Zeichengenerators mit rückgekoppelten, eingangsseitig durch Störbinärfolgen beaufschlagten Schieberegistern (TFa...TFf), die in einer Wirkungsgruppe (1...6) nebeneinander als Schieberegisterstufe (1,3,4) angeordnet sind. wobei mehrere solcher Schieberegisterstufen (1,3,4) untereinander mit einer Wirkungsrichtung von oben nach unten so angeordnet sind. daß die Ausgangssignalfolgen der einzelnen Schieberegister (TFa..TFf) einer Schieberegisterstufe (1) als störende Binärzeichenfolgen für die Schieberegistereingänge der nachgeschalteten Schieberegisterstufe (4) dienen und diesen über steuerbare Zuordner (2) zugeführt werden. und wobei die Ausgangssignale (QZF. QZF1..) des letzten Zuordners (6) oder der letzten Schieberegisterstufe. durch eine Verknüpfungsschaltung (L a...t) verknüpft. die zufallsähnliche Binärzeichenfolge mit langer Periode bilden. dadurch gekennzeichnet. daß der Takteingang mindestens eines Schieberegisters (TFa) des Zeichengenerators (Modul 1. Modul 2) mittel einer Torschaltung (TS1) sperrbar ist daß die Ausgangssignale einer Schieberegisterstufe (1) oder eines steuerbaren Zuordners (2) eines Zeichengenerators durch eine Verknüpfungsschaltung (V1 bzw V2) so verknüpft werden. daß ein für die Periode dieser Stufe bzw dieses Zuordners repräsentatives Signal (a11 bzw. a21) entsteht. daß mehrere Zeichengeneratoren dieser Art betrieben werden und daß die Zeichengeneratoren so miteinander verbunden werden. daß das für die Periode repräsentative Signal (a11 bzw a21) einer Stufe (1) oder eines Zuordners (2) des einen Zeichengenerators (Modul 1) auf den Sperreingang (e11) der Torschaltung (TS1)oder auf den Steuereingang (e21) eines Zuordners (2) eines anderen Zeichengenerators (Modul 2) geführt ist (Figur 2) und dort nach Ablauf der Periode des Teilfolgegenerators (TFa...TFf) des einen Zeichengenerator (Modul 1) die Phasenlage der Impulsfolge des nachgeschalteten Teilfolgegenerators (TFa...TFf) auf dem anderen Zeichengenerator (Modul 2) durch Ausblenden eines Taktimpulses verzögert.

2. Verfahren nach Anspruch 1, dadurch gekennzeichnet, daß die Zeichengeneratoren (Modul 1, Modul 2) kaskaden- oder ringförmig verbunden sind (Figur 2).

3. Verfahren nach einem der vorhergehenden Ansprüche, dadurch gekennzeichnet, daß ein gemeinsamer mittels einer Torschaltung (TS1) sperrbarer Takteingang für die Schieberegister (TFa...TFf) einer ganzen Stufe eines Zeichengenerators (Modul 1, Modul 2) vorgesehen ist (Figur 2).

4. Verfahren nach einem der vorhergehenden Ansprüche, dadurch gekennzeichnet, daß die kaskaden- oder ringförmige Verbindung jeweils zwischen den gleichen Zuordnern (2) bzw. den gleichen Registerstufen (1) der einzelnen Zeichengeneratoren (Modul 1, Modul 2) erfolgt (Figur 2).

5. Verfahren nach einem der vorhergehenden Ansprüche, dadurch gekennzeichnet, daß ein gemeinsamer mittels einer Torschaltung (TS) sperrbarer Takteingang für die Schieberegister (TFa...TFt) eines ganzen Zeichengenerators (Modul 1, Modul 2) vorgesehen ist (Figur 2).

6. Verfahren nach einem der vorhergehenden Ansprüche, dadurch gekennzeichnet, daß die Ausgangssignale von Schieberegisterstufen (1, 3, 4) oder Zuordnern (5) eines Zeichengenerators (Modul 1, Modul 2) durch eine Verknüpfungsschaltung (V bzw. V5) so verknüpft werden, daß ein für die Periode dieses ganzen Zeichengenerators repräsentatives Signal (a10 bzw. a22) entsteht (Figur 2).

7. Verfahren nach Anspruch 6, dadurch gekennzeichnet, daß das repräsentative Signal (a10 bzw. a22) des einen Zeichengenerators (Modul 1) dem Sperreingang (e13) der Torschaltung (TS4) für den Takteingang der letzten Schieberegisterstufe (4) oder dem Steuereingang (e22) des letzten steuerbaren Zuordners (5) des nächsten Zeichengenerators (Modul 2) zugeführt wird (Figur 2).

8. Verfahren nach Anspruch 6 oder 7, soweit Anspruch 6 auf Anspruch 5 besogen ist, dadurch gekennzeichnet, daß das repräsentative Signal (a10) des einen Zeichengenerators (Modul 1) dem Sperreingang (e10) der Torschaltung (TS) für den gemeinsamen Takteingang des nächsten Zeichengenerators (Modul 2) zugeführt wird (Figur 3).

9. Verfahren nach einem der vorhergehenden Ansprüche, dadurch gekennzeichnet, daß der Betrieb der einzelnen Zeichengeneratoren jeweils mit unterschiedlicher Voreinstellung (TFa...TFf) der ersten Schieberegisterstufen (1) erfolgt.

## Claims

1. Method for the generation of random binary symbol sequences of long period with the use of a symbol generator with shift registers (TFa ... TFf), which are acted on at the input by binary noise sequences and provided with feedback and which are arranged one beside the other in an effective group (1 ... 6) as shift register stage (1, 3, 4), wherein several such shift register stages (1, 3, 4) are so arranged one among the other with an effective direction downwards from above that the output signal sequences of the individual shift registers (TFa ... TFf) of a shift register stage (1) serve as binary noise symbol sequences for the shift register inputs of the shift register stage (4) connected therebehind and are fed to this by way of controllable collators (2) and wherein the output signals (QZF, QZF1 . ) of the last collator (6) or of the last shift register stage, which are interlinked by a logic circuit ( a . t) form the random binary symbol sequence of long period, characterised thereby, that the pulse input of at least one shift register (TFa) of the symbol generator (module 1, module 2) is blockable by means of a gate circuit (TS1), that the output signals of a shift register stage (1) or of a controllable collator (2) of a symbol generator are so interlinked by a logic circuit (V1 or V2) that a signal (a11 or a21) arises, which is representative of the period of this stage or of this collator, that several symbol generators of this kind are operated and that the symbol generators are so connected one with the other that the signal (a11 or a21), which is representative of the period, of a stage (1) or of a collator (2) of the one symbol generator (module 1) is conducted to the blocking input (e11) of the gate circuit (TS1) or to the control input (e21) of a collator (2) of another symbol generator (module 2) (Figure 2) and the phase position of the pulse sequence of the downstream partial sequence generator (TFa ... TFf) is delayed on the symbol generator (module 2) by blanking out a clock pulse after run-down of the period of the partial sequence generator (TFa ... TFf) of the one symbol generator (module 1).

2. Method according to claim 2, characterised thereby, that the symbol generators (module 1, module 2) are connected in cascade or in a ring (Figure 2).

3. Method according to one of the preceding claims, characterised thereby, that a common pulse input, which is blockable by means of a gate circuit (TS1), for the shift registers (TFa ... TFf) of an entire stage of a symbol generator (module 1. module 2) is provided (Figure 2).

4. Method according to one of th preceding claims, characterised thereby, that the connection in cascade or in a ring takes place each time between the same collators (2) or the same register stages (1) of the individual symbol generators (module 1. module 2) (Figure 2)

5. Method according to one of the preceding claims. characterised thereby. that a common pulse input. which is blockable by means of a gate circuit (TS) for the shift register (TFa .. TFt) of an entire symbol generator (module 1. module 2) is provided (Figure 2)

6. Method according to one of the preceding claims. characterised thereby. that the output signals of shift register stages (1. 3. 4) or collators (5) of a symbol generator (module 1. module 2) are so interlinked by a logic circuit (V or V5) that a signal (a10 or a22) arises. which is representative of the period of this entire symbol generator (Figure 2)

7. Method according to claim 6 characterised thereby. that the representative signal (a10 or a22) of the one symbol generator (module 1) is conducted to the blocking input (e13) of the gate circuit (TS4) for the pulse input of the last shift register stage (4) or the control input (e22) of the last controllable collator (5) of the next symbol generator (module 2) (Figure 2).

8. Method according to claim 6 or 7 in so far as claim 6 is dependent on claim 5. characterised thereby. that the representative signal (a10) of the one symbol generator (module 1) is conducted to the blocking input (e10) of the gate circuit (TS) for the common pulse input of the next symbol generator (module 2) (Figure 3).

9. Method according to one of the preceding claims, characterised thereby that the operation of the individual symbol generators takes place each time with different presetting (TFa ... TFf) of the first shift register stages (1).

**Revendications**

1. Procédé pour générer des séquences similialéatoires de caractères binaires à longue période, avec utilisation d'un générateur de caractères comprenant des registres à décalage (TFa.-.TFf) à rétroaction, dont les entrées sont alimentées avec des séquences binaires perturbatrices, les registres étant disposés côte à côte en tant qu'étage de registres à décalage (1, 3, 4) dans un sous-ensemble fonctionnel (1...6), plusieurs de ces étages de registres à décalage (1. 3. 4) étant disposés l'un au-dessous de l'autre. avec un sens de fonctionnement allant du haut vers le bas, et la disposition étant telle que les séquences de signaux de sortie des différents registres à décalage (TFa...TFf) d'un étage de registres à décalage (1) servent de séquences de caractères binaires perturbatrices pour les entrées des registres à décalage de l'étage de registres à décalage (4) prévu à la suite et sont amenées à ces entrées à travers des coordonnnateurs (2) pouvant être commandés. les signaux de sortie (QZF. QZF1...) du dernier coordonnateur (6) ou du dernier étage de registres à décalage. combinés par un circuit combinatoire (Σ a. t). formant la séquence simili-aléatoire de caractères binaires à longue période caractérisé en ce que l'entrée d'horloge d'au moins un registre à décalage (TFa) du générateur de caractères (module 1. module 2) peut être bloquée au moyen d'un circuit de porte (TS1). que les signaux de sortie d'un étage de registres à décalage (1) ou d'un coordonnateur (2) pouvant être commandé d'un générateur de caractères. sont combinés. par un circuit combinatoire (V1 ou V2). de manière qu'un signal (a11 ou a21) représentatif de la période de cet étage ou de ce coordonnateur soit formé. que plusieurs générateurs de caractères de ce type sont utilisés et que les générateurs de caractères sont raccordés entre eux de manière que le signal (a11 ou a21) représentatif de la période d'un étage (1) ou d'un coordonnateur (2) du générateur de caractères (module 1) mentionné en premier. soit appliqué à l'entrée de blocage (e11) du circuit de porte (TS1) ou à l'entrée de commande (e21) d'un coordonnateur (2) d'un autre générateur de caractères (module 2) (Fig. 2) et y retarde, après la fin de la période du générateur de séquences partielles (TFa...TFf) du générateur de caractères (module 1) mentionné en premier, la position de phase de la séquence d'impulsions du générateur de séquences partielles (TFa...TFf) monté à la suite, de l'autre générateur de caractères (module 2), par suppression d'une impulsion d'horloge.

2. Procédé selon la revendication 1, caractérisé en ce que les générateurs de caractères (module 1, module 2) sont connectés en cascade ou en anneau (Fig. 2).

3. Procédé selon une des revendications précédentes, caractérisé en ce qu'une entrée d'horloge commune est prévue pour les registres à décalage (TFa...TFf) de tout un étage d'un générateur de caractères (module 1, module 2), entrée d'horloge qui peut être bloquée au moyen du circuit de porte (TS1) (Fig. 2).

4. Procédé selon une des revendications précédentes, caractérisé en ce que la connexion en cascade ou en anneau est réalisée chaque fois entre les mêmes coordonnateurs (2) ou les mêmes étages de registres (1) des différents générateurs de caractères (module 1, module 2) (Fig. 2).

5. Procédé selon une des revendications précédentes, caractérisé en ce qu'une entrée d'horloge commune est prévue pour les registres à décalage (TFa...TFf) de tout un générateur de caractères (module 1, module 2), entrée d'horloge qui peut être bloquée au moyen d'un circuit de porte (TS) (Fig 2).

6. Procédé selon l'une quelconque des revendications précédentes, caractérisé en ce que les signaux de sortie d'étages de registres à décalage (1, 3, 4) ou de coordonnateurs (5) d'un générateur de caractères (module 1, module 2) sont combinés, par un circuit combinatoire (V ou V5), de manière que soit produit un signal (a10 ou a22) représentatif de la période de tout ce générateur de caractères (Fig. 2).

7. Procédé selon la revendication 6, caractérisé en ce que le signal représentatif (a10 ou a22) d'un générateur de caractères (module 1) est appliqué à l'entrée de blocage (e13) du circuit de porte (TS4) pour l'entrée d'horloge du dernier étage de registres à décalage (4) ou à l'entrée de commande (e22) du dernier coordonnateur (5) pouvant être commandé du générateur de caractères suivant (module 2) (Fig. 2).

8. Procédé selon la revendication 6 ou 7, dans la mesure où la revendication 6 se rapporte à la revendication 5, caractérisé en ce que le signal (a10) représentatif du générateur de caractères (module 1) mentionné en premier, est appliqué à l'entrée de blocage (e10) du circuit de porte (TS) pour l'entrée d'horloge commune du générateur de caractères suivant (module 2) (Fig. 3).

9. Procédé selon une des revendications précédentes, caractérisé en ce que les différents générateurs de caractères sont utilisés avec des pré-ajustements différents (TFa...TFf) des premiers étages de registres à décalage (1).

FIG. 1

FIG.2

FIG. 3

FIG. 4a

FIG. 4 b

EP 0 146 865 B1